# EUROPEAN PATENT APPLICATION

(11) **EP 2 426 748 A1**
(43) Date of publication of application: **07.03.2012**
(21) Application number: 11179813.8
(22) Date of filing: 02.09.2011
(51) Int. Cl.: H01L 35/30, H05K 1/02

(54) **Semiconductor unit**

(30) Priority: 07.09.2010 JP 2010200047
(71) Applicant: Kabushiki Kaisha Toyota Jidoshokki, Kariya-shi, Aichi 448-8671 (JP)
(72) Inventor: Morisaku, Naoto, Aichi 448-8671 (JP); Akiyama, Hirokuni, Aichi 448-8671 (JP)
(74) Representative: TBK

(57) **Abstract**

The semiconductor unit includes a wiring board, a conductor layer and a fin. The wiring board has across a thickness thereof a first surface and a second surface. The conductor layer is formed on the first surface of the wiring board. The conductor layer has a length and a width as viewed in the direction of the thickness of the wiring board. The fin is joined to the second surface of the wiring board. The fin has a bent edge that extends in the direction of the length of the conductor layer.

## Description

### BACKGROUND OF THE INVENTION

The present invention relates to a semiconductor unit having at least one of heat absorbing element and heating element, and more particularly to a semiconductor unit suitable for radiating the heat from Peltier device.

Japanese Utility Model Application Publication No. 57-2664 discloses a hybrid integrated circuit unit having a radiator. The hybrid integrated circuit unit has on one side thereof a hybrid integrated circuit board and on the other side thereof the radiator. Functional components are mounted on and wired on the hybrid integrated circuit board. The radiator is made of a heat conductor. The radiator is formed in a corrugated shape and the discrete portions of the corrugated shape are joined to the hybrid integrated circuit board. The surface of the corrugated radiator that is joined to the board has a rectangular shape and the entirety of the rectangular surface is joined to the board by adhesives.

Japanese Utility Model Application Publication No. 64-35788 discloses a mounting structure of ceramic board in which the ceramic board is mounted on the bottom wall of a metal package or on a metal plate via a corrugated plate made of an elastic conductor. The corrugated plate is bent to absorb any warp of the ceramic board. The heat generated by chip component on the ceramic board is radiated via the grooves of the corrugated plate.

In the hybrid integrated circuit unit disclosed by Japanese Utility Model Application Publication No. 57-2664, the radiator is divided into two parts so that the stress caused at the adhesive layer by the difference in coefficient of thermal expansion between the radiator and the board is dispersed. However, this Publication gives consideration only for the stress between the radiator and the board, but no consideration is taken for the stress caused by the difference in coefficient of thermal expansion between the IC chip and the board, with the result that any warp of the board caused by the stress between the IC chip and the board cannot be prevented as required.

In the mounting structure of ceramic board disclosed by Japanese Utility Model Application Publication No. 64-35788, only the stress between the ceramic board and the corrugated plate is considered as in the case of the hybrid integrated circuit unit disclosed by Japanese Utility Model Application Publication No. 57-2664. Any warp of the ceramic board caused by the stress between the chip component and the ceramic board cannot be prevented as required.

The present invention is directed to a semiconductor unit that properly prevents deformation of the wiring board which may be caused by heating of the wiring board and also by heat absorption or heat generation of a conductor layer formed on the wiring board occurring during the manufacturing of the wiring board.

### SUMMARY OF THE INVENTION

In accordance with an aspect of the present invention, the semiconductor unit includes a wiring board, a conductor layer and a fin. The wiring board has across a thickness thereof a first surface and a second surface. The conductor layer is formed on the first surface of the wiring board. The conductor layer has a length and a width as viewed in the direction of the thickness of the wiring board. The fin is joined to the second surface of the wiring board. The fin has a bent edge that extends in the direction of the length of the conductor layer.

Other aspects and advantages of the invention will become apparent from the following description, taken in conjunction with the accompanying drawings, illustrating by way of example the principles of the invention.

### BRIEF DESCRIPTION OF THE DRAWINGS

The invention together with objects and advantages thereof, may best be understood by reference to the following description of the presently preferred embodiments together with the accompanying drawings in which:
Fig. 1 is a cross-sectional side view showing a semiconductor unit according to a first embodiment of the present invention;
Fig. 2 is a cross-sectional front view showing the semiconductor unit of Fig. 1;
Fig. 3 is a plan view showing a wiring board for the semiconductor unit of Fig. 1;
Fig. 4 is a fragmentary perspective view showing radiator fins of the semiconductor unit of Fig. 1;
Fig. 5A is a fragmentary perspective view showing radiator fins of a semiconductor unit according to a first modification of the first embodiment of the present invention;
Fig. 5B is a front view showing the radiator fins of Fig. 5A;
Fig. 6A is a front view showing radiator fins of a semiconductor unit according to a second modification of the first embodiment of the present invention;
Fig. 6B is a front view showing radiator fins of a semiconductor unit according to a third modification of the first embodiment of the present invention;
Fig. 6C is a front view showing radiator fins of a semiconductor unit according to a fourth modification of the first embodiment of the present invention;
Fig. 7 is a fragmentary perspective view showing radiator fins of a semiconductor unit according to a second embodiment of the present invention;
Fig. 8 is a plan view showing a wiring board for the semiconductor unit of Fig. 7; and
Fig. 9 is a front view showing radiator fins of a semiconductor unit according to a third embodiment of the present invention.

### DETAILED DESCRIPTION OF THE EMBODIMENTS

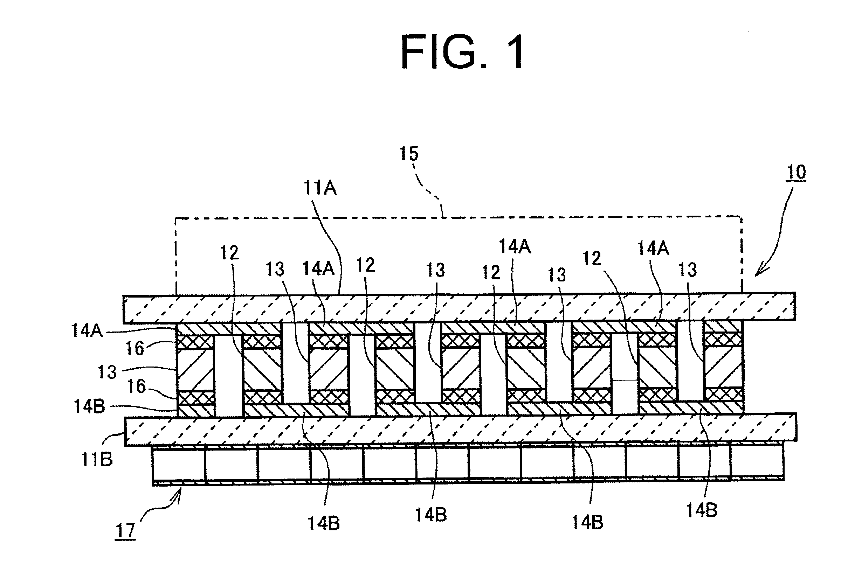

The following will describe the semiconductor unit according to the first embodiment of the present invention with reference to Figs. 1 through 4. A Peltier device is used as the semiconductor unit according to the first embodiment.

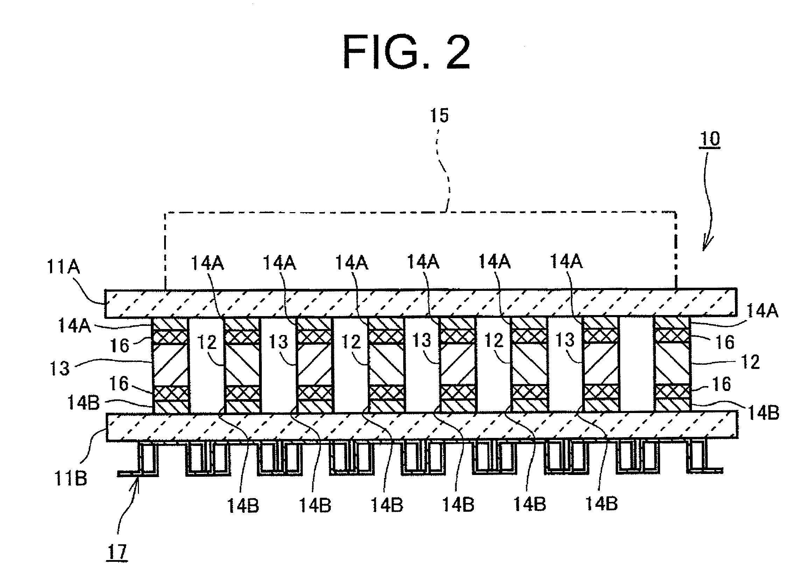

Referring to Fig. 1 showing the semiconductor unit in its cross-sectional side view, the Peltier device 10 has a first board 11A and a second board 11B facing each other. The second board 11 B serves as the wiring board of the present invention. Ceramic material such as aluminum nitride (AIN) is preferably used for the material of the first and second boards 11A and 11B. The ceramic material has a lower coefficient of thermal expansion than metal, also has electrical insulation properties, and further has a higher coefficient of thermal conductivity than aluminum oxide. A plurality of P type semiconductor devices 12 and N type semiconductor devices 13 are disposed alternately between the first and second boards 11A and 11B. Referring to Figs. 1 and 2, a plurality of electrodes 14A is formed on the inner surface of the first board 11A by etching of copper plating and a plurality of electrodes 14B is formed on the inner surface of the second board 11B by etching of copper plating. Each electrode 14B serves as the conductor layer of the present invention. Aluminum may be used instead of copper for the electrodes 14A and 14B, in which case the electrodes 14A and 14B are formed by brazing rather than by etching.

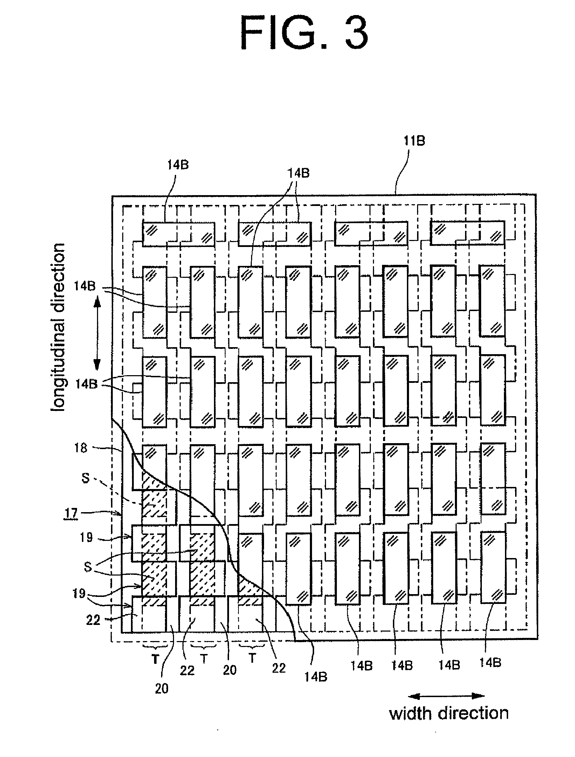

Referring to Fig. 3, the vertical direction and lateral direction as seen in the drawing correspond to the longitudinal direction and width direction of the second board 11 B, respectively. The electrodes 14B, except the four electrodes 14B at the top in the drawing, has such a rectangular shape in plan view that the dimension along the longitudinal direction (or the direction of length) of the second board 11B is larger than the dimension along the width direction (or the direction of width). As shown in Fig. 3, the electrodes 14B are arranged in a regular manner on the second board 11 B. The electrodes 14B are arranged on the inner surface of the second board 11B in such orientation that the longitudinal directions of the electrodes 14B coincide with the longitudinal direction of the second board 11 B. It is noted that four electrodes 14B at the rear end (or at the upper end of Fig. 3) are arranged in such orientation that their longitudinal directions coincide with the width direction of the second board 11B. In the present embodiment, the intervals of the electrodes 14B in the respective longitudinal direction and width direction of the second board 11 B are set substantially the same.

Although not shown in the drawings, the electrodes 14A of the first board 11A are arranged in a regular manner on the first board 11A as in the case of the electrodes 14B of the second board 11B. It is noted that the electrodes 14A at the front end (or at the lower end of Fig. 3) on the first board 11 A are arranged in such orientation that their longitudinal directions coincide with the width direction of the first board 11A. The other electrodes 14A are arranged on the inner surface of the first board 11A in such orientation that the longitudinal directions of the electrode 14A coincide with the longitudinal direction of the first board 11A.

As shown in Fig. 1, the P type semiconductor devices 12 and the N type semiconductor devices 13 are electrically connected in series via the electrodes 14A and 148. Each P type semiconductor device 12 is joined at one surface thereof to the first board 11A via the corresponding electrode 14A and at the other surface thereof to the second board 11B via the corresponding electrode 14B. Each N type semiconductor device 13 is joined at one surface thereof to the first board 11A via the corresponding electrode 14A and at the other surface thereof to the second board 11B via the corresponding electrode 14B. A heat absorber 15 is joined to the outer surface (or the upper surface) of the first board 11A in Fig. 1 or 2, and radiator fins 17 are joined to the outer surface (or the lower surface) of the second board 11 B in Fig. 1 or 2. The heat absorber 15 may be provided by absorber fins that have the same structure as the radiator fins 17. The heat absorber 15 and the radiator fins 17 may be replaced by the radiator and the absorber fins, respectively, by changing the direction of current flowing through both of the P type semiconductor devices 12 and the N type semiconductor devices 13. The radiator fins 17 serve as the fin of the present invention. The inner surface of the second board 11B facing the first board 11A serves as the first surface of the wiring board of the present invention and the outer surface of the second board 11B serves as the second surface of the wiring board of the present invention, respectively.

As shown in Figs. 1 and 2, the opposite surfaces of each P type semiconductor device 12 are joined to the electrodes 14A and 14B via solder 16, respectively. Similarly, the opposite surfaces of each N type semiconductor device 13 are joined to the electrodes 14A and 14B via solder 16, respectively. When current is flowed through the Peltier device 10, heat is transferred between the P type semiconductor devices 12 and the N type semiconductor devices 13, so that a temperature difference occurs between the first board 11A and the second board 11 B and one of the first board 11A and the second board 11 B serves to absorb heat and the other serves to radiate heat. Thus, the heat absorber 15 is cooled and the radiator fins 17 are heated.

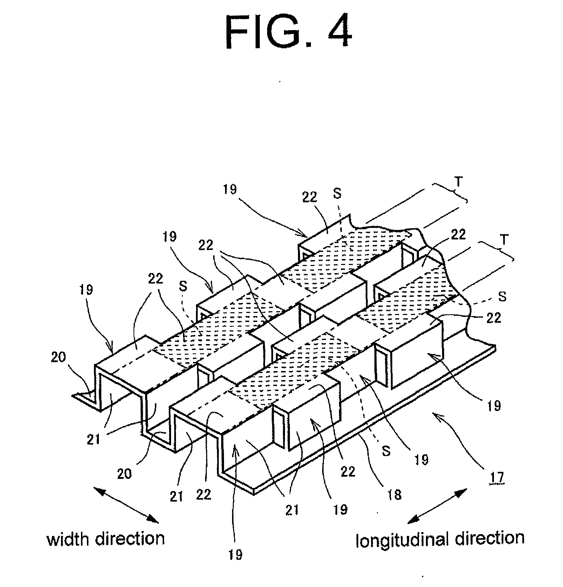

The following will describe more in detail the radiator fins 17 joined to the second board 11 B of the Peltier device 10. As shown in Figs. 3 and 4, the radiator fins 17 are an offset fin and made of copper that is the same as the material of the electrodes 14A and 14B. The radiator fins 17 are formed by bending a metal plate and have a base 18 and a plurality of projections 19 projecting from the base 18.

As shown in Fig. 4, the base 18 has a plurality of bottom walls 20 formed between the projections 19. Each projection 19 has a pair of vertical walls 21 that extends vertically from the bottom walls 20 and a top wall 22 that extends parallel to the bottom walls 20 to interconnect the distal ends of the paired vertical walls 21. The projections 19 are spaced in the width of the radiator fins 17 so as to form a plurality of longitudinal rows of projections extending in the longitudinal direction of the radiator fins 17 (or the direction along which the metal plate is bent). The rows of the projections 19 are spaced in the width direction of the radiator fins 17 so that the projections and recesses are formed alternately in the width direction of the radiator fins 17. Thus, a series of square waves including projections and recesses is formed in the width direction of the radiator fins 17. That is, the radiator fins 17 are bent to have bent edges at the boundaries between each bottom wall 20 and the corresponding vertical walls 21 and also at the boundaries between each vertical wall 21 and the corresponding top wall 22. In the present embodiment, the vertical walls 21 and the bottom walls 20 of the radiator fins 17 serve to radiate heat. The vertical walls 21 and the bottom walls 20 of the radiator fins 17 serve as the heat transfer portion of the present invention.

As shown in Fig. 4, the projections 19 in each longitudinal row are formed continuously in an offset manner so that any two adjacent projections 19 are offset in the width direction of the radiator fins 17. Each top wall 22 of the radiator fins 17 serves as the joining portion of the present invention. The surface of each top wall 22 joined to the second board 11 B serves as the joining surface of the present invention. Each longitudinal row of the projections 19 has on the top walls 22 thereof a joining area T that extends in the longitudinal direction of the radiator fins 17 in a straight line with a constant width. The width of the joining area T is the same as that of each electrode 14B. In the present embodiment, there are overlap regions (indicated by shading in Fig. 4) between the radiator fins 17 and the electrodes 14B as viewed in thickness direction (or direction of thickness) of the second board 11B. Part of the top walls 22 of the radiator fins 17 is located in each overlap region as viewed in the thickness direction of the second board 11 B. The entire overlap regions are located in the top walls 22 as viewed in the thickness direction of the second board 11B. In addition, there are separation regions between any two adjacent overlap regions that are juxtaposed in the width direction of the radiator fins 17. The ratio of the area of the joining surfaces of the top walls 22 that coincide with each overlap region to the area of the overlap region is set larger than that of the area of the joining surfaces of the top walls 22 that coincide with each separation region to the area of the separation region.

The vertical walls 21 of the radiator fins 17 extend in the longitudinal direction of the radiator fins 17 have stiffness against bending across the longitudinal direction thereof to resist the deformation caused by the thermal stress. On the other hand, the radiator fins 17 having bent edges in the width direction thereof are elastically deformable in the width direction thereof. That is, the radiator fins 17 that are elastically deformable in the width direction thereof are hard to be elastically deformed across the longitudinal direction thereof by the stiffness.

With the radiator fins 17 fixed to the second board 11 B by brazing as shown in Figs. 1 and 2, the top walls 22 are joined to the heat radiating surface of the second board 11B. A plurality of projections 19 of each row are formed continuously in the longitudinal direction of the electrode 14B. The longitudinal directions of the electrodes 14B coincide with the direction in which the bent edges of the radiator fins 17 extend. The direction in which any two adjacent projections 19 in each longitudinal row are offset coincides with the width direction of the electrodes 14A.

With the radiator fins 17 fixed to the second board 11B, the electrodes 14B and the top walls 22 are disposed in overlapping relation to each other across the second board 11B. That is, the top walls 22 are located so as to correspond to the electrodes 14B. The areas S of the electrodes 14B as projected in plan view are located within the joining area T in each row of projections 19, as shown in Figs. 3 and 4. Each joining area T extends continuously in the longitudinal direction of the electrodes 14B.

The following will describe in detail the heat radiation of the semiconductor unit according to the first embodiment. When current is flowed through the Peltier device 10, heat is transferred between the P type semiconductor devices 12 and the N type semiconductor devices 13 thereby to cause a temperature difference between the first board 11A and the second board 11B. Thus, the first board 11A serving to absorb heat is cooled while the second board 11 B serving to radiate heat is heated. With respect to the heat transfer in the second board 11 B, the heat of the second board 11 B is transferred to the vertical walls 21 and the bottom walls 20 via the surfaces (or joining surfaces) of the top walls 22 joined to the second board 11B. The heat of the vertical walls 21 and the bottom walls 20 of the projections 19 of the radiator fins 17 is radiated to heat medium such as air or any other fluids flowing through the radiator fins 17.

Heat generated by the electrodes 14B causes thermal stress to be developed in the second board 11B due to a relatively large difference in the coefficient of thermal expansion between the second board 11B and the electrodes 14B. The thermal stress causes deformation such as warp of the second board 11B. In the present embodiment, the electrodes 14B and the top walls 22 that are made of the same material develop thermal stresses of the same magnitude to the second board 11B thereby to cancel the deformation of the second board 11B caused by the thermal stresses, which prevents the deformation of the entire second board 11B.

The heat of the electrodes 14B is transferred to the radiator fins 17. Thermal stress occurs in the outer surface of the second board 11B due to the difference in coefficient of thermal expansion between the second board 11B and the radiator fins 17. Of the thermal stress occurring in the outer surface of the second board 11 B, the thermal stress acting in the width direction of the second board 11 B and causing the deformation of the second board 11 B is absorbed by the elastic deformation of the radiator fins 17 in the width direction thereof. Although the thermal stress acting in the longitudinal direction of the electrodes 14B urges the second board 11 B to warp across the longitudinal direction of the second board 11 B, the stiffness of the radiator fins 17 in the longitudinal direction thereof resists the thermal stress causing the deformation of the second board 11B. Thus, such thermal stress acting in the longitudinal direction of the electrodes 14B causes no deformation of the second board 11B.

In the present embodiment, the areas S of the electrodes 14B as projected in plan view are located within the joining area T in each row of the projections 19. Thus, the heat of the electrodes 14B is rapidly transferred to the radiator fins 17 via the joining areas T corresponding to the respective electrodes 14B, which makes it easy to prevent the deformation of the second board 11 B caused by the thermal stress due to the difference in coefficient of thermal expansion between the second board 11 B and the electrodes 14B.

In the present embodiment, the areas S of the electrodes 14B as projected in plan view are located within the joining area T extending in the longitudinal direction of the electrodes 14B in each row of the projections 19, and the electrodes 14B and the radiator fins 17 are both made of the same copper. If the joining areas T and the projected areas S of the electrodes 14B are the same in both area and shape, the top walls 22 and the electrodes 14B are the same in both thickness and material, and the joining areas T and the projected areas S of the electrodes 14B are disposed in overlapping relation to each other, the deformation of the second board 11 B caused by the thermal stress is canceled. In the present embodiment wherein the joining areas T and the projected areas S of the electrodes 14B are disposed overlapping each other for a substantial area, the deformation of the second board 11B caused by the thermal stress generated by the respective electrodes 14B and the deformation of the second board 11 B caused by the thermal stress generated in the projected areas S of the electrodes 14B located in the joining areas T are approximate to each other. That is, the thermal stress generated by the electrodes 14B and causing the deformation of the second board 11 B is substantially canceled by the thermal stress generated by the electrodes 14B in the projected areas S and causing the deformation of the second board 11B. Consequently, the deformation of the second board 11B is prevented.

In fixing the radiator fins 17 to the second board 11B by soldering, the radiator fins 17 absorb by its elastic deformation the thermal stress in the width direction of the electrodes 14B caused by soldering and resists the thermal stress in the longitudinal direction of the electrodes 14B by its stiffness. Thus, the deformation of the second board 11B is prevented in the same manner as in the case when the Peltier device 10 is in operation.

The above-described first embodiment offers the following advantageous effects.
(1) The radiator fins 17 joined to the second board 11B have stiffness against bending across the longitudinal direction of the radiator fins 17 to resist the deformation caused by the thermal stress in the longitudinal direction of the radiator fins 17 and is elastically deformable in the direction perpendicular to the longitudinal direction of the radiator fins 17. The heat of the electrodes 14B of the second board 11B is absorbed by the radiator fins 17 and then radiated from the radiator fins 17. Of the thermal stress occurring in the second board 11B, the thermal stress acting in the width direction of the electrodes 14B and causing the deformation of the second board 11 B is absorbed by the elastic deformation of the radiator fins 17 in the width direction thereof and the thermal stress acting in the longitudinal direction of the electrodes 14B and causing the deformation of the second board 11B is resisted by the stiffness of the radiator fins 17. Thus, the deformation of the second board 11 B is prevented.
(2) The heat of the electrodes 14B is absorbed by the radiator fins 17 via the joining areas T corresponding to the electrodes 14B. Thus, the heat of the electrodes 14B of the second board 11B is easily transferred to the radiator fins 17, which makes it easy to prevent the deformation of the second board 11B caused by the thermal stress.
(3) The width of the joining areas T is the same as that of the electrodes 14B and the areas S of the electrodes 14B are located within the joining areas T. The heat of the electrodes 14B of the second board 11 B that is absorbed by the radiator fins 17 via the areas S in the joining areas T is further easily transferred to the radiator fins 17, which prevents the deformation of the second board 11 B caused by the thermal stress.
(4) In the present embodiment wherein the electrodes 14B and the radiator fins 17 are made of the same material, the deformation of the second board 11 B caused by the thermal stress generated by the respective electrodes 14B and the deformation of the second board 11 B caused by the thermal stress generated in the projected areas S of the electrodes 14B located in the corresponding joining areas T are approximate to each other. That is, the deformation of the second board 11 B caused by the thermal stress generated by the electrodes 14B is canceled by the deformation of the second board 11B caused by the thermal stress generated by the joining areas T. Therefore, any warp of the second board 11B due to the heat of the electrodes 14B is substantially prevented.
(5) Since the radiator fins 17 are of an offset type fin, the radiator fins 17 joined to the second board 11B may be made as a single part. Using the offset fin makes it easy to form the joining areas T. The radiator fins 17 made in a single part help to facilitate their mounting to the second board 11B by brazing. Thus, the semiconductor unit is easily manufactured.
(6) Flowing electric current repeatedly through the Peltier device 10 develops thermal stress which causes the second board 11 B to be deformed. However, the provision of the radiator fins 17 serves to reduce the deformation of the second board 11B due to the thermal stress, thereby increasing the lifetime of the Peltier device 10 and the soldered joint.

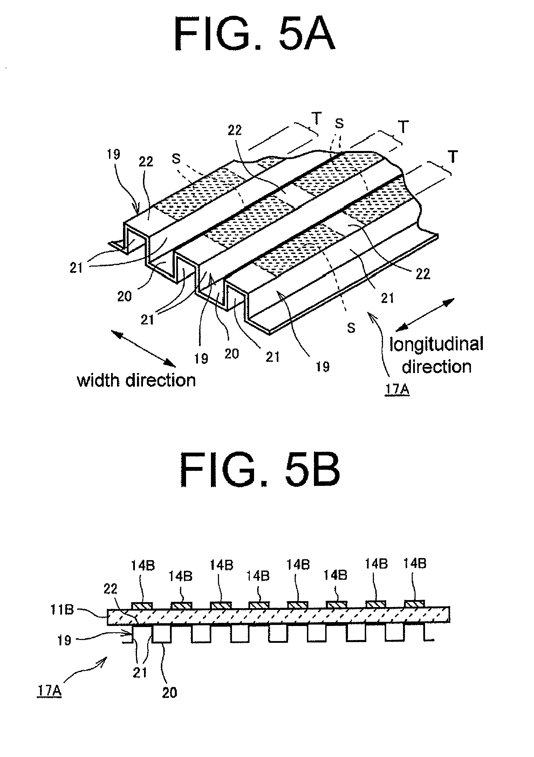

The following will describe the radiator fins 17A of the semiconductor unit according to the first modification of the first embodiment of the present invention with reference to Figs. 5A and 5B. The radiator fins 17A of the first modification are a straight fin having a plurality of straight projections 19 extending in the longitudinal direction (or in the direction of the bent edge) of the radiator fins 17A. The projections 19 are juxtaposed in the width direction of the radiator fins 17A (or in the direction perpendicular to the direction of the bent edge). In the present embodiment, there are overlap regions (indicated by shading in Fig. 5A) between the radiator fins 17A and the electrodes 14B as viewed in thickness direction of the second board 11B. Part of the top walls 22 of the radiator fins 17A is located in each overlap region as viewed in the thickness direction of the second board 11B. The entire overlap regions are located in the top walls 22 of the radiator fins 17A as viewed in the thickness direction of the second board 11 B. Each projection 19 of the radiator fins 17A has a pair of vertical walls 21 that extends vertically from the bottom walls 20 and a top wall 22 that extends parallel to the bottom walls 20 to interconnect the distal ends of the paired vertical walls 21. The entire joining surfaces of the top walls 22 joined to the electrodes 14B correspond to the joining areas T and the width of the top wall 22 is the same as that of the electrodes 14B. A plurality of areas S of the electrodes 14B as projected in plan view is located in each joining area T or on each top wall 22. The radiator fins 17A having in the width direction thereof a plurality of bent edges extending along the longitudinal direction of the radiator fins 17A are elastically deformable in the width direction thereof and has stiffness against bending across the longitudinal direction thereof. Although the semiconductor unit according to the present first modification offers substantially the same effects as the semiconductor unit according to the first embodiment, the straight fin according to the first modification is structurally simpler and hence made easier than the offset fin according to the first embodiment.

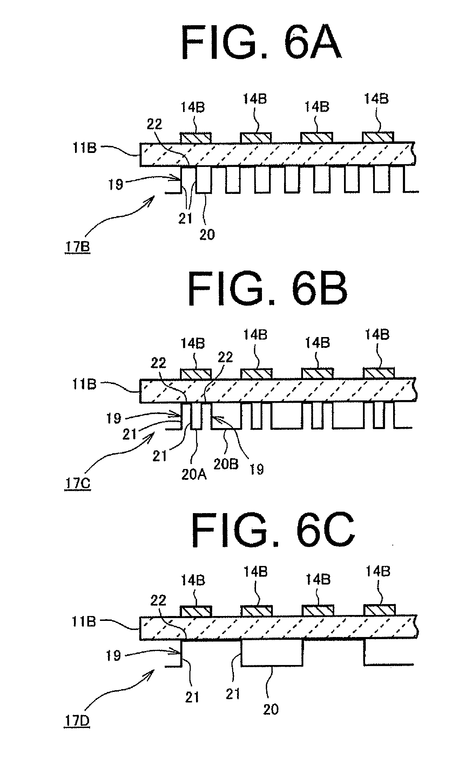

The following will describe the radiator fins 17B through 17D of the semiconductor units according to the second through fourth modifications of the first embodiment of the present invention with reference to Figs. 6A through 6C. Each of the radiator fins 17B-17D is a straight fin as in the case of the first modification of Figs. 5A and 5B. In the radiator fins 17B of Fig. 6A, the radiator fins 17B are formed with the spaced distance between the opposed vertical walls 21 of any two adjacent projections 19 in the width direction of the radiator fins 17B set half the corresponding interval in the case of the first modification. In the second modification, there are overlap regions between the radiator fins 17B and the electrodes 14B as viewed in thickness direction of the second board 11B. The ratio of the area of the joining surface of the top wall 22 that coincides with each overlap region to the area of the overlap region is 1/2. In the second modification, there are separation regions between any two adjacent overlap regions that are juxtaposed in the width direction of the radiator fins 17B. The ratio of the area of the joining surface of the top wall 22 that coincides with each overlap region to the area of the overlap region is the same as that of the area of the joining surface of the top wall 22 that coincides with each separation region to the area of the separation region.

In the radiator fins 17C of Fig. 6B, the projections 19 of the radiator fins 17C are spaced at two different intervals. More specifically, when there are overlap regions between the radiator fins 17C and the electrodes 14B as viewed in thickness direction of the second board 11B, the radiator fins 17C are formed at the overlap regions with the spaced distance between the opposed vertical walls 21 of any two adjacent projections 19 in the width direction of the radiator fins 17C set one third the corresponding interval in the case of the first modification. When there are separation regions between any two adjacent overlap regions that are juxtaposed in the width direction of the radiator fins 17C, the radiator fins 17C are formed at the separation regions with the spaced distance between the opposed vertical walls 21 in the width direction of the radiator fins 17C set the same as the corresponding interval in the case of the first modification. Thus, narrow bottom walls 20A and broad bottom walls 20B are formed in the radiator fins 17C as shown in Fig. 6B. In the third modification, the ratio of the area of the joining surface of the top wall 22 that coincides with each overlap region to the area of the overlap region is 2/3. The ratio of the area of the joining surface of the top wall 22 that coincides with each overlap region to the area of the overlap region is set larger than that of the area of the joining surface of the top wall 22 that coincides with each separation region to the area of the separation region.

In the radiator fins 17D of Fig. 6C, the projections 19 of the radiator fins 17D are spaced at an interval that is twice as large as that in the case of the first modification of Fig. 5B. Thus, the electrode 14B does not overlap with the entirety of its corresponding top wall 22 of the radiator fins 17D across the second board 118 as viewed in the thickness direction of the second board 11B. As shown in Fig. 6C, the radiator fins 17D are formed in such a way that the electrodes 14B overlapping with the top wall 22 of the radiator fins 17D across the second board 11 B alternate with the electrodes 14B overlapping with no top wall 22 of the radiator fins 17D. In the fourth modification of Fig. 6C, there are overlap regions between the radiator fins 17D and the electrodes 14B as viewed in thickness direction of the second board 11B. The ratio of the area of the joining surface of the top wall 22 that coincides with each overlap region to the area of the overlap region is zero or 1. In the fourth modification, there are separation regions between any two adjacent overlap regions that are juxtaposed in the width direction of the radiator fins 17D. The ratio of the area of the joining surface of the top wall 22 that coincides with each separation region to the area of the separation region is zero or 1.

As in the case of the first embodiment, each of the radiator fins 17A-17D of the first through fourth modifications absorbs the deformation caused by the thermal stress in the width direction of the electrodes 14B by its elastic deformation and resists the deformation caused by the thermal stress in the longitudinal direction of the electrodes 14B by its stiffness. Thus, the deformation of the second board 11 B is prevented.

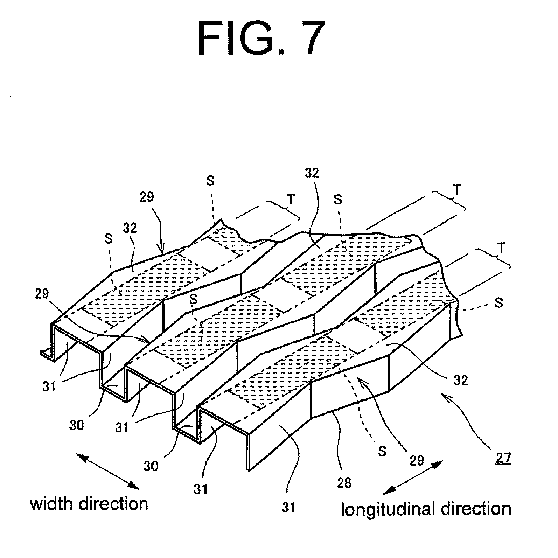

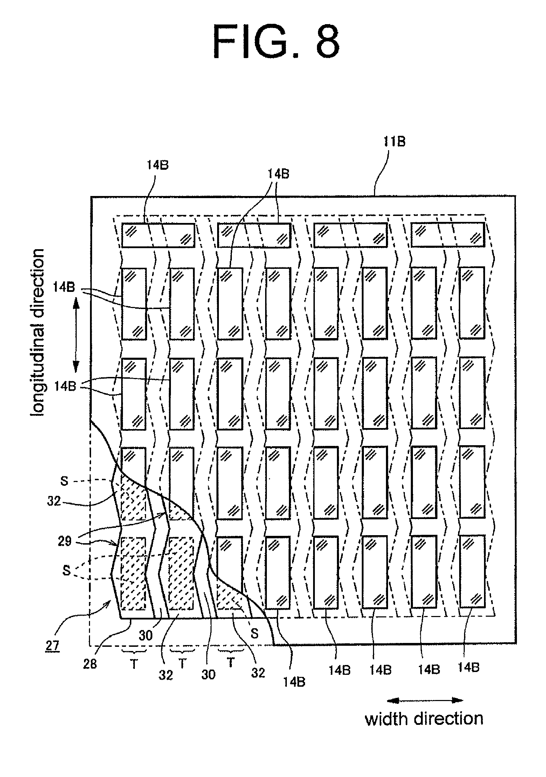

The following will describe the semiconductor unit according to the second embodiment of the present invention with reference to Figs. 7 and 8. The second embodiment differs from the first embodiment in that the radiator fins 27 corresponding to the radiator fins 17 of the first embodiment are elastically deformable not only in the width direction of the radiator fins 27 but also in the longitudinal direction of the radiator fins 27. Since the second embodiment is the same as the first embodiment in structure other than the radiator fins, the description about the common elements or parts of the second embodiment is omitted by incorporating the description of the first embodiment and the same reference numerals of the first embodiment are used for the common elements or parts of the first and second embodiments.

Referring to Figs. 7 and 8, the radiator fins 27 are made of copper that is used for the electrodes 14A and 14B. The radiator fins 17 are formed by bending a metal plate and have a base 28 and a plurality of projections 29 projecting from the base 28. As shown in Fig. 7, each projection 29 has a pair of vertical walls 31 that vertically extends from the bottom walls 30 and a top wall 32 that extends parallel to the bottom walls 30 to interconnect the distal ends of the paired vertical walls 31. The projections 29 are formed at intervals in width direction of the radiator fins 27. As shown in Fig. 7, the radiator fins 27 are formed with a series of alternate square projections and square recesses in the width direction of the radiator fins 27. That is, the radiator fins 27 are bent to have bent edges at the boundaries between each bottom wall 30 and the corresponding vertical walls 31 and also at the boundaries between each vertical wall 31 and the corresponding top wall 32. In the present embodiment, the vertical walls 31 and the bottom walls 30 of the radiator fins 27 serve to radiate heat. The vertical walls 31 and the bottom walls 30 of the radiator fins 27 serve as the heat transfer portion of the present invention.

As shown in Fig. 7, the paired vertical walls 31 of the radiator fins 27 in the present embodiment are bent in a zigzag manner in the direction of the bent edge of the radiator fins 27. The paired vertical walls 31 are spaced so that the width of the bottom wall 30 is constant and that the width of the top wall 32 is also constant. As mentioned above, the top wall 32 is formed in a zigzag manner in the longitudinal direction of the entire bent edges of the radiator fins 27 in a planar view of the radiator fins 27. In the present embodiment, the longitudinal direction of the entire bent edges of the radiator fins 27 serves as the direction in which the bent edge of the present invention extends. Each projection 29 of the radiator fins 27 has on the top wall 32 thereof a joining area T that extends in the longitudinal direction with a constant width. The width of the joining area T is the same as that of the electrode 14B. In the present embodiment, there are overlap regions (indicated by shading in Fig. 7) between the radiator fins 27 and the electrodes 14B as viewed in thickness direction of the second board 11 B. Part of the top walls 22 of the radiator fins 27 is located in each overlap region as viewed in the thickness direction of the second board 11 B. The entire overlap regions are located in the top walls 22 as viewed in the thickness direction of the second board 11B. In addition, there are separation regions between any two adjacent overlap regions that are juxtaposed in the width direction of the radiator fins 27. The ratio of the area of the joining surface of the top wall 32 that coincides with each overlap region to the area of the overlap region is set larger than that of the area of the joining surface of the top wall 32 that coincides with each separation region to the area of the separation region.

The vertical walls 31 which are bent in a zigzag manner in the longitudinal direction of the radiator fins 27 are elastically deformable in the longitudinal direction of the radiator fins 27. Thus, the radiator fins 27 are elastically deformable not only in the width direction of the radiator fins 27 but also in the longitudinal direction of the radiator fins 27. It is noted that the thickness of the radiator fins 27 is set larger than that of the radiator fins 17 of the first embodiment.

With the radiator fins 27 fixed to the second board 11B by brazing as shown in Fig. 8, the top walls 32 are joined to the heat radiating surface of the second board 11B. Each projection 29 of the radiator fins 27 is formed extending continuously in the longitudinal directions of the electrodes 14B. The longitudinal directions of the electrodes 14B and the longitudinal direction of the entire bent edges of the radiator fins 27 are the same.

With the radiator fins 27 fixed to the second board 11B, the electrodes 14B and the top walls 32 are disposed in overlapping relation to each other across the second board 11 B. That is, the top wall 32 that serves as the joining portion of the present invention is located so as to correspond to the electrodes 14B. The area S of the electrodes 14B on the second board 11B as projected in plan view is located in the corresponding joining area T as shown in Figs. 7 and 8. The joining area T is formed continuously in the longitudinal direction of the electrode 14B.

The second embodiment offers substantially the same effects as the effects (2) through (5) of the first embodiment. In the present embodiment, the radiator fins 27 joined to the second board 11 B are elastically deformable in the longitudinal direction of the entire bent edges and also in the direction perpendicular to the longitudinal direction of the entire bent edges. It is noted that the degree of the elastic deformation (or the deformation amount per stress for a given stress level) in the direction perpendicular to the longitudinal direction of the entire bent edges is much larger than that of the elastic deformation in the longitudinal direction of the entire bent edges. That is, the radiator fins 27 have a certain level of stiffness against bending across the longitudinal direction of the radiator fins 27. The heat of the electrodes 14B of the second board 11 B is absorbed by the radiator fins 27 and then radiated from the radiator fins 27. Of the thermal stress occurring in the second board 11 B, the thermal stress acting in the width direction of the electrodes 14B and causing the deformation of the second board 11B is absorbed by the elastic deformation of the radiator fins 27 and the thermal stress acting in the longitudinal direction of the electrodes 14B and causing the deformation of the second board 11 B is resisted by the stiffness of the radiator fins 27. Thus, the deformation of the second board 11B is prevented.

In the radiator fins 17 of the first embodiment having stiffness against bending across the longitudinal direction thereof, if the thickness of the second board 11B is increased, the thermal stress occurring in the outer surface of the second board 11 B may become larger than the thermal stress occurring in the inner surface of the second board 11 B. Thus, the second board 11B may not resist the thermal stress acting in the longitudinal direction of the radiator fins 27 and causing the deformation. In the radiator fins 27 of the present embodiment, however, the radiator fins 27 are deformed in the longitudinal direction thereof so that the thermal stress occurring in the inner surface of the second board 11B becomes the same as the thermal stress occurring in the outer surface of the second board 11B. Thus, the deformation of the second board 11B is prevented. The radiator fins 17 may be formed in accordance with the relation between the thickness of the radiator fins and the thickness of the second board 11B having the electrodes 14B so as to have stiffness that resists the thermal stress acting in the longitudinal direction of the radiator fins 17 and causing the deformation of the second board 11 B as in the case of the first embodiment. Alternatively, the radiator fins 27 may be formed so as to be elastically deformable in the longitudinal direction of the radiator fins 27 as in the case of the second embodiment. Reducing the thickness of the electrode 14B of the first embodiment, the radiator fins 17 may be formed so as to be elastically deformable in the longitudinal direction of the radiator fins 17 as in the case of the second embodiment. Thus, the second board 11B is prevented from being warped.

Although in the radiator fins 27 of the present embodiment there is one-to-one correspondence between the rows of the electrodes 14B and the projections 29, the electrodes 14B and the projections 29 may be arranged otherwise. The radiator fins may be formed so that each projection is bent with a large angle toward the width direction of the radiator fins and also that one projection corresponds to two rows of the electrodes 14B. In this case, the electrodes 14B and the projections 29 are of two-to-one correspondence.

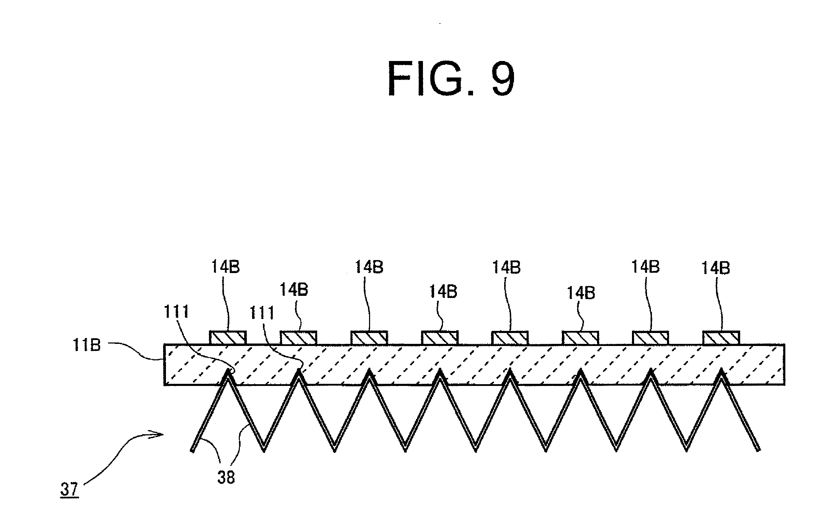

The following will describe the semiconductor unit according to the third embodiment of the present invention with reference to Fig. 9. In the present embodiment, a plurality of grooves formed in the longitudinal direction of the second board 11B are formed in the surface of the second board 11B to which radiator fins 37 corresponding to the radiator fins 17 of the first embodiment are fixed. The grooves are formed in the width direction of the second board 11B. The radiator fins 37 are of a triangular fin which is formed in a zigzag manner as viewed in longitudinal direction of the radiator fins 37. The radiator fins 37 do not have substantially the bottom walls and the top walls of the first embodiment, but have inclined walls. The description about the common elements or parts of the third embodiment is omitted by incorporating the description of the first embodiment and the same reference numerals of the first embodiment are used for the common elements or parts of the first and third embodiments.

As shown in Fig. 9, a plurality of electrodes 14B each serving as the conductor layer of the present invention are formed on one surface (or the first surface) of the second board 11B and the radiator fins 37 are joined to the other or outer surface (or the second surface) of the second board 11B. The surface of the second board 11B to which the radiator fins 37 are fixed has a plurality of grooves 111 disposed in the width direction of the second board 11B. Each groove 111 has a V shape as viewed in the longitudinal direction of the second board 11B. Although not shown in the drawing, each groove 111 is formed across the length of the radiator fins 37 thereby to improve the bending strength against the thermal stress in the longitudinal direction of the radiator fins 37.

Although the radiator fins 37 have a plurality of bent edges, the radiator fins 37 have substantially no bottom wall and no top wall unlike the first embodiment. The radiator fins 37 are formed by bending a metal plate and have walls 38 formed continuously and inclined in alternate directions. The bent edges of the radiator fins 37 form the top and bottom of the radiator fins 37. The distance between any two adjacent tops of the radiator fins 37 is the same as the distance between the any two adjacent grooves 111 of the second board 11B.

In the present embodiment, the radiator fins 37 are fixed to the second board 11B with the radiator fins 37 inserted at the top thereof in the grooves 111 of the second board 11B. With the radiator fins 37 thus inserted in the grooves 111 of the second board 11B, the radiator fins 37 and the second board 11 B are in surface-to-surface contact with each other. The joint strength between the second board 11 B and the radiator fins 37 by surface-to-surface contact is greater than the strength by line contact. By forming the grooves 111 in the second board 11B, the radiator fins 37 having substantially no top wall may be fixed to the second board 11B. In addition, by forming the grooves 111 in the second board 11 B, the bending strength against the thermal stress in the longitudinal direction of the radiator fins 37 is improved. Thus, the deformation caused by the thermal stress is prevented.

Forming the grooves 111 in the second board 11B is not limited to the case of the radiator fins 37. In the fin having a small stiffness in the longitudinal direction of the second board 11 B, forming the grooves 111 in the second board 11 B is effective in reducing the deformation across the longitudinal direction of the second board 11B.

In the present embodiment wherein the radiator fins 37 having substantially no top wall is joined to the second board 11B by using the grooves 111, the cross sectional shape of the groove is not limited and the shape of the joined radiator fins is freely determined. Radiator fins 17, 17A-17D and 27 having the top walls as in the cases of the first and second embodiments (including the modifications) may be used instead of the radiator fins 37 in the third embodiment. In this case, grooves are formed in the second board 11 B with a shape that conforms to the respective top walls of the radiator fins 17, 17A-17D and 27.

The present invention has been described in the context of the above embodiments, but it is not limited to the embodiments. It is obvious to those skilled in the art that the invention may be practiced in various manners as exemplified below.

Although in the above-described embodiments the board (or the second board) of the Peltier device is used for the wiring board, any wiring board having a radiator element other than Peltier device may be used. Any wiring board having a transformer or a power controlling electronic component may be used.

Although in the above-described embodiments any one of the offset fin, the straight fin and the triangular fin is used as the radiator fins, such fins as herringbone fin, perforated fin or serrated fin may be used.

Although in the above-described embodiments rectangular electrodes are used as the conductor layer, the shape of the conductor layer is not limited to a rectangle. According to the present invention, the conductor layer is required to have a dimension that extends in longitudinal direction. The shape of conductor layer excludes regular polygon such as square and circle having no longitudinal direction but includes a rectangle and an oval.

Although in the above-described embodiments the materials of the radiator fins and the conductor layer are the same, the materials of the radiator fins and the conductor layer may be different. Any material may be used for the radiator fins and the conductor layer as long as the thermal stress generated between the joining surface of the radiator fins and the wiring board and the thermal stress generated between the conductor layer and the wiring board are distributed so as to cancel each other.

Although in the above-described embodiments the width of the joining portion (joining area T) of the radiator fins is substantially the same as that of the conductor layer (the projected area S on the surface of electrode), the width of the joining portion of the radiator fins does not need to be the same as that of the conductor layer as long as the thermal stress generated between the joining surface of the radiator fins and the wiring board and the thermal stress generated between the conductor layer and the wiring board are distributed so as to cancel each other.

Although in the above-described embodiments the radiator fins that serve as the fin of the present invention have been described, the absorber fins that serve also as the fin of the present invention may be used by changing the direction of current flowing through the Peltier device. In the case of the absorber fins wherein the heat transfer occurs in opposite direction, the same effect as in the case of the radiator fins may be accomplished.

## Claims

1. A semiconductor unit comprising:
a wiring board (11A, 11B) having across a thickness thereof a first surface and a second surface;
a conductor layer (14A, 14B) formed on the first surface of the wiring board (11A, 11B); and
a fin (15, 17, 17A, 17B, 17C, 17D, 27, 37) joined to the second surface of the wiring board (11A, 11 B),
**characterized in that**
the conductor layer (14A, 14B) has a length and a width as viewed in the direction of the thickness of the wiring board (11A, 11 B),
wherein the fin (15, 17, 17A, 17B, 17C, 17D, 27, 37) has a bent edge that extends in the direction of the length of the conductor layer (14A, 14B).

2. The semiconductor unit according to claim 1, **characterized in that** the conductor layer (14A, 14B) is one of a plurality of conductor layers (14A, 14B) formed on the first surface of the wiring board (11A, 11B), the conductor layers (14A, 14B) having respective lengths and widths as viewed in the direction of the thickness of the wiring board (11A, 11B), the conductor layers (14A, 14B) being located so that the directions of the lengths coincide with each other, the fin (15, 17, 17A, 17B, 17C, 17D, 27) having a joining portion and a heat transfer portion that extends from the joining portion, wherein there are overlap regions between the fin (15, 17, 17A, 17B, 17C, 17D, 27) and the conductor layers (14A, 14B) as viewed in the direction of the thickness of the wiring board (11A, 11 B), wherein at least part of the joining portion of the fin (15, 17, 17A, 17B, 17C, 17D, 27) is located in each overlap region as viewed in the direction of the thickness of the wiring board (11A, 11B).

3. The semiconductor unit according to claim 2, **characterized in that** a ratio of area of the joining portion that is located in each overlap region as viewed in the direction of the thickness of the wiring board (11B) to area of the overlap region is 1/2 or more.

4. The semiconductor unit according to claim 2 or 3, **characterized in that** the conductor layers (14B) are located so that the directions of the widths coincide with each other, wherein when at least two of the overlap regions are juxtaposed in the direction of the width of the conductor layer (14B), there is at least a separation region between the overlap regions juxtaposed in the direction of the width of the conductor layer (14B), wherein a ratio of area of the joining portion that is located in each overlap region as viewed in the direction of the thickness of the wiring board (11 B) to area of the overlap region is set larger than a ratio of area of the joining portion that is located in the separation region as viewed in the direction of the thickness of the wiring board (11 B) to area of the separation region.

5. The semiconductor unit according to claim 2 or 3, **characterized in that** the joining portion has a joining area (T) that extends in the direction of the length of the conductor layer (14B) in a straight line with a constant width, the width of the joining area (T) being the same as width of each conductor layer (14B).

6. The semiconductor unit according to claim 5, **characterized in that** the conductor layers (14B) and the fin (17, 17A, 27) are made of the same material.

7. The semiconductor unit according to claim 5 or 6, **characterized in that** the fin (17) is an offset fin and the conductor layers (14B) are disposed so as to correspond to the joining area (T).

8. The semiconductor unit according to any one of claims 2 through 7, **characterized in that** the joining portion of the fin (17) is one of a plurality of joining portions of the fin (17), wherein the joining portions of the fin (17) are formed continuously in the direction of the length of the conductor layer (14B), wherein the conductor layers (14B) are located so that the directions of the widths coincide with each other, wherein two adjacent joining portions formed continuously in the direction of the length of the conductor layer (14B) are offset in the direction of the width of the conductor layer (14B).

9. The semiconductor unit according to any one of claims 2 through 8, **characterized in that** the heat transfer portion is formed in a zigzag manner in a direction in which the bent edge of the fin (27) extends.

10. The semiconductor unit according to any one of claims 2 through 9, **characterized in that** the conductor layers (14B) are located so that the directions of the widths coincide with each other, wherein intervals of the conductor layers (14B) in the direction of the width thereof are substantially the same, wherein each conductor layer (14B) is provided with a P-type semiconductor device (12) and an N-type semiconductor device (13).

11. The semiconductor unit according to any one of claims 1 through 9, **characterized in that** the second surface of the wiring board (11B) has a groove (111) that is formed in the direction of the length of the conductor layer (14B), wherein the fin (37) is joined to the wiring board (11B) with the fin (37) inserted in the groove (111) of the wiring board (11 B).
